# EUROPEAN PATENT SPECIFICATION

(11) **EP 2 693 642 B1**
(45) Date of publication and mention of the grant of the patent: **18.07.2018**
(21) Application number: 13178464.7
(22) Date of filing: 30.07.2013
(51) Int. Cl.: H03L 5/00, H03L 7/099

(54) **Method & apparatus for controlling gain in a voltage controlled oscillator**
Verfahren und Vorrichtung zur Verstärkungsregelung in einem spannungsgesteuerten Oszillator
Procédé et appareil de commande de gain dans un oscillateur contrôlé par la tension

(30) Priority: 31.07.2012 GB 201213566
(43) Date of publication of application: 05.02.2014
(73) Proprietor: Frontier Microsystems Limited, London NW1 2AA (GB)
(72) Inventor: Schiff, Albrecht Johannes, Didcot, Oxfordshire OX11 8DG (GB)
(74) Representative: Lind, Robert

(56) References cited:
- US-A1- 2004 212 443
- US-A1- 2004 251 971
- US-A1- 2006 139 104
- US-A1- 2009 289 723

## Description

### Technical Field

The invention relates to a method and apparatus for controlling amplitude in a voltage controlled oscillator. The invention is of particular use in wireless communications systems and equipment.

### Background to the Invention

Circuits, such as phase locked loops, may use a voltage controlled oscillator (VCO) to control the frequency of oscillations produced by the phase locked loop. In VCOs the frequency of oscillations is controlled by an input voltage allowing the frequency or phase of a VCO's output signal to be varied with respect to an input reference signal.

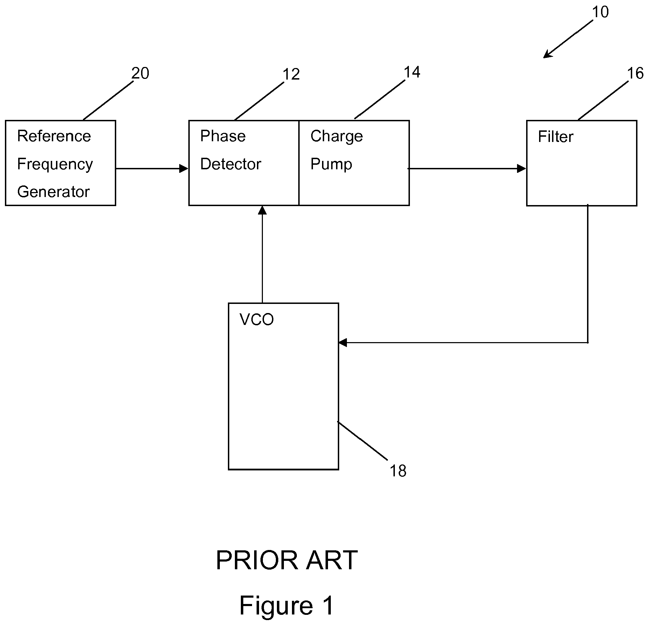

An example of a phase locked loop including a VCO is illustrated in Figure 1. A phase locked loop 10 such as that illustrated in Figure 1 generally includes a phase detector 12, a charge pump 14, a loop filter 16 and a VCO 18.

The phase detector 12 receives two input signals - a reference input from a reference frequency generator 20 and a feedback signal from the VCO 18. The phase detector 12 compares the two input signals and produces an error signal which is proportional to their phase difference. The charge pump 14 receives the error signal and adjusts the voltage according to predetermined parameters. Finally the loop filter 16, which is generally a low-pass filter, determines how the loop 10 responds to disturbances and limits how much of the reference frequency energy is input into the VCO 18.

Optionally, the phase locked loop 10 may be provided with a divider (not shown) between the VCO 18 and the phase detector 12. The divider acts to divide the frequency of the VCO's output signal in order that it is a multiple of the reference frequency.

Traditionally, VCOs are provided with a fixed current supply in order that the current consumed by the oscillator can be controlled. A fixed current supply also limits any noise introduced into the output signal by other components in a circuit. However, having a fixed input current does not allow other factors, such as temperature variations, supply voltage or substrate interference, which affect the VCO's output amplitude to be compensated for. Thus, in fixed current VCOs the current is set high enough to ensure the VCOs performance meets required parameters at all required variations in these factors; however, this results in a large power consumption by the VCO.

Thus, rather than having a fixed current some VCOs are provided with a control loop. The control loop generates a control signal to control the current supplied to the VCO which in turn controls the VCO's oscillation amplitude.

Whilst the use of a control loop to control the current into the VCO allows variations in factors affecting the oscillation of the VCO to be taken into account the use of additional components also introduces noise into the circuit which is undesirable.

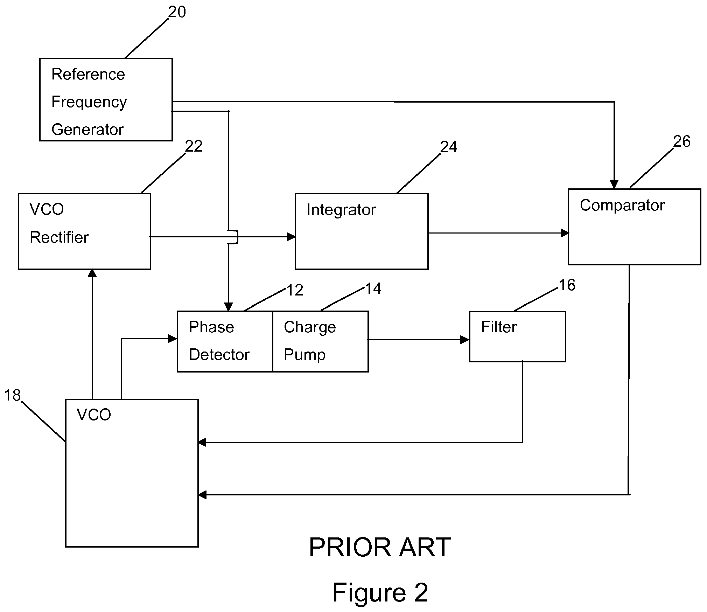

US Patent number 6,812,802 describes the use of additional elements in combination with a phase locked loop to control the effects of noise. This device is illustrated in Figure 2. In this device the phase locked loop is constructed as described above with reference to Figure 1 with like components being labelled with the same reference numerals.

The additional circuit includes a rectifier 22 to rectify the signal output by the VCO 18. The rectifier 22 produces a rectified signal proportional to the amplitude of the output signal. The rectified signal is received by an integrator 24 which controls the rate of change of the signal depending on the mode of operation.

The signal output by the integrator 24 is received by a comparator 26 where it is compared to the reference signal produced by the reference signal generator 20 to produce a bias signal. The bias signal is then input into the VCO 18 to control the gain of the VCO 18. This means that when the VCO is being started up it can be configured to have a high gain enabling the VCO to lock on quickly. The mode of the integrator may then be changed when the VCO has achieved lock to reduce the effect of noise on the VCO and increase its stability.

US-A-2004/251971 describes a method and apparatus for controlling a voltage controlled oscillator.

### Summary of the Invention

According to an aspect of the present invention there is provided an apparatus to control amplitude in a voltage controlled oscillator (VCO). The apparatus includes means to measure the amplitude of the VCO output, comparison means to compare the measured amplitude with a reference amplitude and a variable bandwidth filter comprising two resistors arranged in parallel and a capacitor, each resistor having a different resistance, and further comprising means to alter the total resistance of the bandwidth filter by selecting one of the two resistors to configure the bandwidth filter to receive the results of the comparison and generate a bias signal; wherein the bias signal controls the current supplied to the VCO. Altering the resistance of a resistor in the variable bandwidth filter enables easy alteration of the bandwidth of the variable bandwidth filter. By controlling the bandwidth of the variable bandwidth filter the effect of amplitude changes on the size of the current input into the VCO can be moderated to optimise the function of the VCO both when starting and locking onto the required phase and then once it has locked on.

The means to measure the amplitude of the VCO output may be a rectifier.

Optionally, the means to measure the amplitude of the VCO output is configured to convert the amplitude of the VCO output to a voltage representing the amplitude and the comparison means is configured to compare the voltage representing the measured amplitude to a reference amplitude and comprises comparing the voltage representing the amplitude to a reference voltage. By converting the amplitude to a voltage the difference between a measured amplitude and a reference amplitude can readily be determined.

The means to select may be a switch. For example, the switch may be in series with the one of the two resistors having the lowest resistance or alternatively may be a three-way switch configured to selectively direct the output signal through one of the two resistors.

Alternatively, the resistor may be a potentiometer and the means to alter the resistance of the variable bandwidth filter comprises a processor configured to control the resistance of the variable resistor.
The comparison means may be a comparator or error amplifier.

In accordance with another aspect of the present invention there is provided a method of controlling amplitude in a voltage controlled oscillator. The method includes the steps of measuring the amplitude of the VCO output, comparing the measured amplitude to a reference amplitude and processing the result of the comparison in a variable bandwidth filter to produce a bias signal, altering the bandwidth of the variable bandwidth filter by altering the resistance of the variable bandwidth filter,
The bandwidth filter comprises two resistors arranged in parallel and a capacitor, each resistor having a different resistance, and the step of altering the resistance of the variable bandwidth filter comprises selecting a resistor from the two resistors. The bias signal is used the bias signal to control the current supplied to the VCO thereby controlling the amplitude of oscillations produced by the VCO.

Measuring the amplitude of the VCO output may comprise converting the amplitude of the VCO output to a voltage representing the amplitude and comparing the measured amplitude to a reference amplitude may comprise comparing the voltage representing the amplitude to a reference voltage.

Selecting the resistor may comprise selectively opening and closing a switch in series with one of the resistors or alternatively, altering the configuration of a three-way switch to direct the output signal through one of the two resistors.

Alternatively, selecting the resistance of the resistor may comprise setting a resistance of a variable resistor.

Altering the bandwidth of the variable bandwidth filter may comprise increasing the bandwidth of the variable bandwidth filter when the VCO is locking on and decreasing the bandwidth of the variable bandwidth filter when the VCO has locked on to a phase.

### Brief Description of the Drawings

Figure 1 illustrates a traditional phase locked loop;
Figure 2 illustrates a prior art phase locked loop including amplitude control;
Figure 3 illustrates a phase locked loop including gain control according to an embodiment of the present invention; and
Figure 4 illustrates a method of controlling gain of a VCO.

### Detailed Description

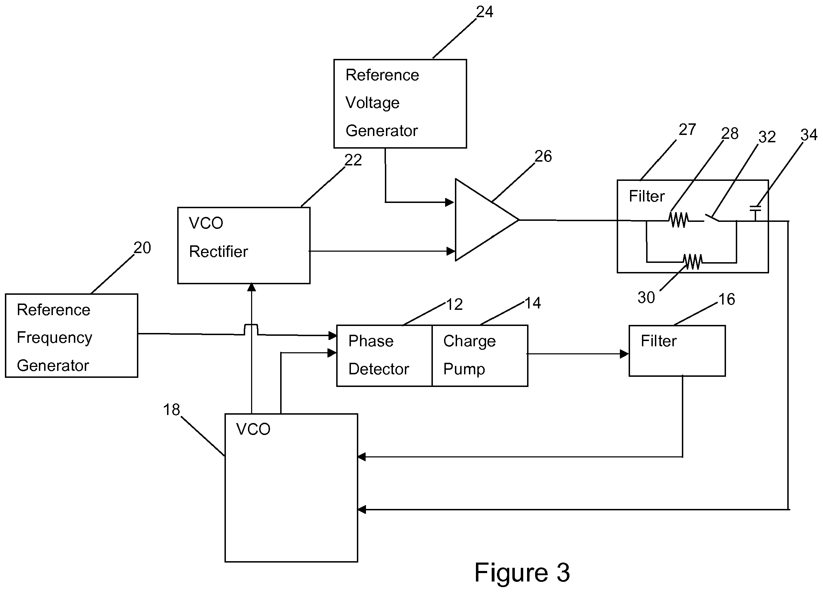

The apparatus illustrated in Figure 3 includes a phase locked loop such as that described with reference to Figure 1 with like reference numerals denoting like components. In Figure 3 the phase locked loop includes, phase detector 12, a charge pump 14 and a loop filter 16. The skilled person will understand that the phase locked loop may also include a divider (not shown) between the VCO output and the phase detector.

The loop additionally includes an amplitude control circuit for controlling the amplitude of the oscillations of the VCO. The gain control circuit includes a rectifier 22, a reference voltage generator 24, an error amplifier 26 and a variable bandwidth filter 27. The variable bandwidth filter includes two resistors 28, 30, a switch 32 and a capacitor 34.

The rectifier 22 acts to rectify the signal output by the VCO to produce a rectified signal having a voltage proportional to the amplitude of the VCO's output signal's oscillations.

The error amplifier 26 receives the rectified signal having the voltage proportional to the amplitude of the VCO's output signal's oscillations at one input and a reference voltage output by the reference voltage generator 24 to output an error signal equal to the difference between the voltage of the rectified signal and the reference voltage.

The error signal is received by the variable bandwidth filter 27 which processes the error signal to produce a bias signal. The variable bandwidth filter 27 includes two resistors 28, 30 have difference resistances and being arranged in parallel. The switch 32 in the variable filter 32 is situated in series with the resistor 28 with the lowest resistance. This location of the switch enables the switch to control which resistor the error signal passes through. Finally, the capacitor 34 is located in parallel with the signal input into the variable bandwidth filter 27.

The bias signal produced by the variable bandwidth filter 27 controls the current which is input into the VCO 18. As the amplitude of oscillations of the VCO is dependent upon the current input into the VCO controlling the bandwidth of the variable bandwidth filter enables control of the change of amplitude of oscillations in the VCO.

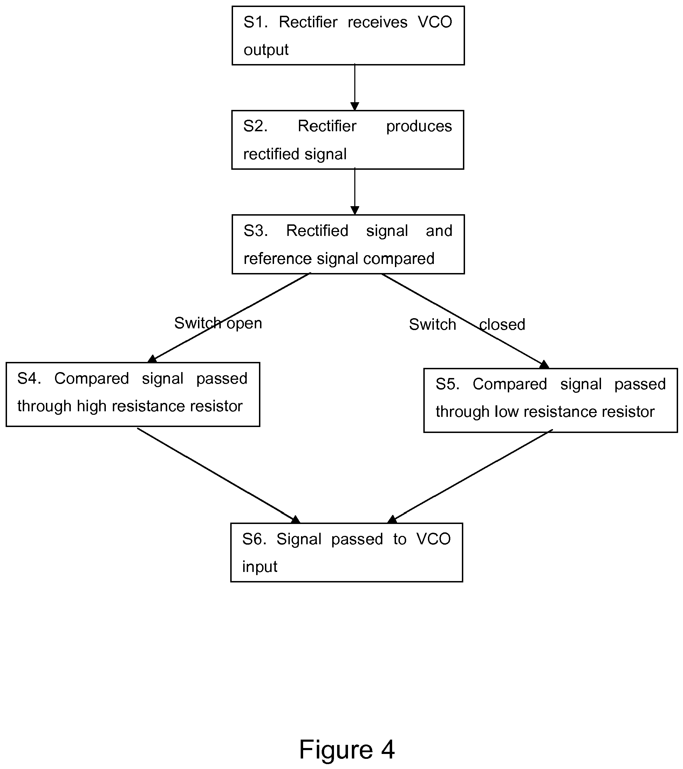

Figure 4 illustrates how the amplitude control circuit controls the gain of the VCO. In S1 the output of the VCO is input into the rectifier which produces a rectified signal (S2). As discussed previously the rectified signal has a voltage which is proportional to the amplitude of the oscillations output by the VCO.

The rectified signal is input into an error amplifier which also receives, at its other input, a reference voltage from the reference voltage generator. As discussed above the voltage of the rectified signal and the reference voltage is compared in the error amplifier and the error amplifier outputs an error signal representative of the difference between the voltage of the rectified signal and the reference voltage (S3). The error signal is transmitted by the error amplifier and passes to the variable bandwidth filter.

When the switch 32 in the variable bandwidth filter is closed the error signal passes through the resistor having the smallest resistance (S4) and is then output by the variable bandwidth filter for input into the VCO (S6). In such a configuration the bandwidth of the variable bandwidth filter is wide enabling a fast change of the amplitude of oscillations of the signal output by the VCO and therefore fast correction of the amplitude of the VCO. Preferably the switch is closed when the VCO is in start-up as it allows the VCO to lock on quickly.

Alternatively, when the switch in the variable bandwidth filter is open the error signal passes through the resistor with the higher resistance (S5) and is then output by the variable bandwidth filter for input into the VCO (S6). When the error signal passes through the resistor with the greater resistance the effect of any noise in the VCO due to the presence of circuit components can be minimised whilst allowing the loop to correct any drift in the current due to leakage, temperature or voltage changes.

The skilled person will understand from the above description that the rectified VCO signal gets filtered and will essentially be a voltage. This voltage is compared to a reference voltage. Optionally, there is no filter to compare the voltage representing the oscillations of the VCO output and the reference voltage but rather the parasitic capacitances in the circuit will have that effect.

Any suitable means may be used to control the switch. For example, a processor may detect the change in output by the VCO and if it is greater than a predetermined amount the switch is closed. Conversely if the rate of change is less than a predetermined amount then the switch is opened.

Rather than providing a switch in a series with the resistor with the smallest resistance the switch may be a three-way switch which acts to control which resistor the error signal passes through.

Optionally, instead of providing two resistors in parallel any suitable variable resistor may be provided between the error amplifier and the VCO. For example, the variable resistance may be a potentiometer. The resistance of the variable resistor may be controlled by a processor so that the resistance of the variable resistor is lower when the VCO is in start up and larger when the VCO has locked on.

Whilst the present invention has been described with reference to two different resistances the skilled person will understand that any number of resistances may be used in order that the required control of the gain in the VCO may be achieved. For example, three or more resistors may be placed in parallel with a switch directing the signal through one or a combination of resistors.

Although the circuit has been described with reference to an error amplifier comparing the voltage of the rectified signal to a reference voltage the skilled person will understand that any suitable device may be used to compare the two signals. For example, it may alternatively be a comparator.

Further, although the circuit has been described with reference to a rectifier producing a voltage representing the amplitude of the oscillations of the VCO the skilled person will understand that any suitable device may be used to convert the size of amplitude of the oscillations output by the VCO into a voltage. Additionally, any property of an electrical signal, not necessarily voltage, may be used to represent the amplitude of oscillations and may be compared to a reference value of that property.

## Claims

1. Apparatus to control amplitude in a voltage controlled oscillator (VCO) comprising:
means to measure the amplitude of the VCO output;
comparison means to compare the measured amplitude with a reference amplitude and
a variable bandwidth filter (27) **characterised in that** the variable bandwidth filter comprises two resistors (28, 30) arranged in parallel and a capacitor, each resistor having a different resistance, and further comprising means to alter the total resistance of the bandwidth filter by selecting one of the two resistors to configure the bandwidth filter to receive the results of the comparison and generate a bias signal; wherein the bias signal controls the current supplied to the VCO.

2. Apparatus as claimed in claim 1 wherein the means to measure the amplitude of the VCO output is configured to convert the amplitude of the VCO output to a voltage representing the amplitude, and the comparison means is configured to compare the voltage representing the measured amplitude to a reference amplitude and comprises comparing the voltage representing the amplitude to a reference voltage.

3. Apparatus as claimed in claim 1 wherein the means to select comprises a switch (32) in series with one of the resistors (28, 30) or a three-way switch configured to selectively direct the output signal through one of the two resistors (28, 30).

4. Apparatus as claimed in claim 1 wherein the resistor (28, 30) is a potentiometer and the means to alter the resistance of the variable bandwidth filter (27) comprises a processor configured to control the resistance of the variable resistor (28, 30).

5. Apparatus as claimed in any one of the preceding claims wherein the means to measure the amplitude of the VCO output comprises a rectifier (22) and/or the comparison means is a comparator or error amplifier (26).

6. A method of controlling amplitude in a voltage controlled oscillator, VCO, (18) comprising:
measuring the amplitude of the VCO output;
comparing the measured amplitude to a reference amplitude; and
processing the result of the comparison in a variable bandwidth filter (27) to produce a bias signal, and wherein the bandwidth filter comprises two resistors (28, 30) arranged in parallel and a capacitor (34), each resistor having a different resistance;
altering the bandwidth of the variable bandwidth filter (27) by altering the resistance of the variable bandwidth filter (27), wherein altering the resistance of the variable bandwidth filter (27) comprises selecting a resistor (28, 30) from the two resistors (28, 30).
using the bias signal to control the current supplied to the VCO (18).

7. A method as claimed in claim 6 wherein measuring the amplitude of the VCO output comprises converting the amplitude of the VCO output to a voltage representing the amplitude and comparing the measured amplitude to a reference amplitude comprises comparing the voltage representing the amplitude to a reference voltage.

8. A method as claimed in claim 7 wherein selecting the resistor (28, 30) comprises selectively opening and closing a switch (32) in series with one of the resistors (28, 30) or altering the configuration of a three-way switch (32) to direct the output signal through one of the two resistors (28, 30).

9. A method as claimed in claim 7 wherein the step of selecting the resistance of the resistor (28, 30) comprises setting a resistance of a variable resistor (28, 30).

10. A method as claimed in claim any one of claims 7 to 9 wherein altering the bandwidth of the variable bandwidth filter (27) comprises increasing the bandwidth of the variable bandwidth filter (27) when the VCO is locking on and decreasing the bandwidth of the variable bandwidth filter (27) when the VCO (18) has locked on to an amplitude.

## Patentansprüche

1. Vorrichtung, um die Amplitude in einem spannungsgesteuerten Oszillator (VCO) zu steuern, umfassend:
ein Mittel, um die Amplitude des VCO-Ausgangs zu messen;
ein Vergleichsmittel, um die gemessene Amplitude mit einer Referenzamplitude zu vergleichen; und
ein Filter mit veränderlicher Bandbreite (27), das **dadurch gekennzeichnet ist, dass** das Filter mit veränderlicher Bandbreite zwei parallel angeordnete Widerstände (28, 30) und einen Kondensator umfasst, wobei jeder Widerstand einen anderen Widerstandswert hat, und das ferner ein Mittel umfasst, um den Gesamtwiderstandswert des Bandbreitenfilters zu verändern, indem einer der beiden Widerstände ausgewählt wird, um das Bandbreitenfilter dafür zu konfigurieren, die Ergebnisse des Vergleichs zu empfangen und ein Vorspannungssignal zu erzeugen; worin das Vorspannungssignal den Strom steuert, der dem VCO zugeführt wird.

2. Vorrichtung nach Anspruch 1, worin das Mittel, um die Amplitude des VCO-Ausgangs zu messen, dafür konfiguriert ist, die Amplitude des VCO-Ausgangs in eine Spannung zu konvertieren, welche die Amplitude darstellt, und das Vergleichsmittel dafür konfiguriert ist, die Spannung, welche die gemessene Amplitude darstellt, mit einer Referenzspannung zu vergleichen, und umfasst: Vergleichen der Spannung, welche die gemessene Amplitude darstellt, mit einer Referenzspannung.

3. Vorrichtung nach Anspruch 1, worin das Mittel zum Auswählen einen Schalter (32) in Reihe mit einem der Widerstände (28, 30) oder einen Dreiwegeschalter umfasst, der dafür konfiguriert ist, das Ausgangssignal wahlweise durch einen der beiden Widerstände (28, 30) zu leiten.

4. Vorrichtung nach Anspruch 1, worin der Widerstand (28, 30) ein Potentiometer ist und das Mittel, um den Widerstandswert des Filters mit veränderlicher Bandbreite (27) zu verändern, einen Prozessor umfasst, der dafür konfiguriert ist, den Widerstandswert des veränderlichen Widerstandes (28, 30) zu steuern.

5. Vorrichtung nach einem der vorhergehenden Ansprüche, worin das Mittel, um die Amplitude des VCO-Ausgangs zu messen, einen Gleichrichter (22) umfasst und/oder das Vergleichsmittel ein Komparator oder Fehlerverstärker (26) ist.

6. Verfahren zum Steuern der Amplitude in einem spannungsgesteuerten Oszillator (VCO), (18), umfassend:
Messen der Amplitude des VCO-Ausgangs;
Vergleichen der gemessenen Amplitude mit einer Referenzamplitude; und
Verarbeiten des Ergebnisses des Vergleichs in einem Filter mit veränderlicher Bandbreite (27), um ein Vorspannungssignal zu erzeugen, und worin das Bandbreitenfilter zwei parallel angeordnete Widerstände (28, 30) und einen Kondensator (34) umfasst, wobei jeder Widerstand einen anderen Widerstandswert hat;
Verändern der Bandbreite des Filters mit veränderlicher Bandbreite (27) durch Verändern des Widerstandswerts des Filters mit veränderlicher Bandbreite (27), worin das Verändern des Widerstandswerts des Filters mit veränderlicher Bandbreite (27) umfasst: Auswählen eines Widerstandes (28, 30) aus den beiden Widerständen (28, 30), und
Verwenden des Vorspannungssignals, um den Strom zu steuern, der dem VCO (18) zugeführt wird.

7. Verfahren nach Anspruch 6, worin das Messen der Amplitude des VCO-Ausgangs umfasst: Konvertieren der Amplitude des VCO-Ausgangs in eine Spannung, welche die Amplitude darstellt, und das Vergleichen der gemessenen Amplitude mit einer Referenzamplitude umfasst: Vergleichen der Spannung, welche die Amplitude darstellt, mit einer Referenzspannung.

8. Verfahren nach Anspruch 7, worin das Auswählen des Widerstandes (28, 30) umfasst: wahlweises Öffnen und Schließen eines Schalters (32) in Reihe mit einem der Widerstände (28, 30) oder Verändern der Konfiguration eines Dreiwegeschalters (32), um das Ausgangssignal durch einen der beiden Widerstände (28, 30) zu leiten.

9. Verfahren nach Anspruch 7, worin der Schritt des Auswählens des Widerstandswerts des Widerstandes (28, 30) umfasst: Einstellen eines Widerstandswerts eines veränderlichen Widerstandes (28, 30).

10. Verfahren nach einem der Ansprüche 7 bis 9, worin das Verändern der Bandbreite des Filters mit veränderlicher Bandbreite (27) umfasst: Erhöhen der Bandbreite des Filters mit veränderlicher Bandbreite (27), wenn der VCO synchronisiert, und Vermindern der Bandbreite des Filters mit veränderlicher Bandbreite (27), wenn der VCO (18) sich mit einer Amplitude synchronisiert hat.

## Revendications

1. Appareil pour contrôler l'amplitude dans un oscillateur contrôlé en tension (VCO), comprenant :
un moyen pour mesurer l'amplitude de la sortie de VCO ;
un moyen de comparaison pour comparer l'amplitude mesurée à une amplitude de référence ; et
un filtre à bande passante variable (27), **caractérisé en ce que** le filtre à bande passante variable comprend deux résistances (28, 30) qui sont agencées en parallèle et un condensateur, chaque résistance présentant une valeur de résistance différente, et comprenant en outre un moyen pour altérer la valeur de résistance totale du filtre à bande passante variable en sélectionnant l'une des deux résistances de manière à configurer le filtre à bande passante variable de sorte qu'il reçoive les résultats de la comparaison et qu'il génère un signal de polarisation ; dans lequel le signal de polarisation contrôle le courant qui est alimenté sur le VCO.

2. Appareil selon la revendication 1, dans lequel le moyen pour mesurer l'amplitude de la sortie de VCO est configuré de manière à ce qu'il convertisse l'amplitude de la sortie de VCO selon une tension qui représente l'amplitude, et le moyen de comparaison est configuré de manière à ce qu'il compare la tension qui représente l'amplitude mesurée à une amplitude de référence et comprend la comparaison de la tension qui représente l'amplitude à une tension de référence.

3. Appareil selon la revendication 1, dans lequel le moyen pour sélectionner comprend un commutateur (32) qui est en série avec l'une des résistances (28, 30) ou un commutateur à trois voies qui est configuré de manière à ce qu'il dirige de façon sélective le signal de sortie au travers de l'une des deux résistances (28, 30).

4. Appareil selon la revendication 1, dans lequel la résistance (28, 30) est un potentiomètre et le moyen pour altérer la valeur de résistance du filtre à bande passante variable (27) comprend un processeur qui est configuré de manière à ce qu'il contrôle la valeur de résistance de la résistance variable (28, 30).

5. Appareil selon l'une quelconque des revendications précédentes, dans lequel le moyen pour mesurer l'amplitude de la sortie de VCO comprend un redresseur (22) et/ou le moyen de comparaison est un comparateur ou un amplificateur d'erreur (26).

6. Procédé pour contrôler une amplitude dans un oscillateur contrôlé en tension, VCO, (18), comprenant :
la mesure de l'amplitude de la sortie de VCO ;
la comparaison de l'amplitude mesurée à une amplitude de référence ; et
le traitement du résultat de la comparaison dans un filtre à bande passante variable (27) afin de produire un signal de polarisation, et dans lequel le filtre à bande passante variable comprend deux résistances (28, 30) qui sont agencées en parallèle et un condensateur (34), chaque résistance présentant une valeur de résistance différente ;
l'altération de la bande passante du filtre à bande passante variable (27) en altérant la valeur de résistance du filtre à bande passante variable (27), dans lequel l'altération de la valeur de résistance du filtre à bande passante variable (27) comprend la sélection d'une résistance (28, 30) parmi les deux résistances (28, 30) ; et
l'utilisation du signal de polarisation afin de contrôler le courant qui est alimenté sur le VCO (18).

7. Procédé selon la revendication 6, dans lequel la mesure de l'amplitude de la sortie de VCO comprend la conversion de l'amplitude de la sortie de VCO selon une tension qui représente l'amplitude et la comparaison de l'amplitude mesurée à une amplitude de référence comprend la comparaison de la tension qui représente l'amplitude à une tension de référence.

8. Procédé selon la revendication 7, dans lequel la sélection de la résistance (28, 30) comprend, de façon sélective, l'ouverture et la fermeture d'un commutateur (32) qui est en série avec l'une des résistances (28, 30) ou l'altération de la configuration d'un commutateur à trois voies (32) de manière à ce qu'il dirige le signal de sortie au travers de l'une des deux résistances (28, 30).

9. Procédé selon la revendication 7, dans lequel l'étape de sélection de la valeur de résistance de la résistance (28, 30) comprend le réglage d'une valeur de résistance d'une résistance variable (28, 30).

10. Procédé selon l'une quelconque des revendications 7 à 9, dans lequel l'altération de la bande passante du filtre à bande passante variable (27) comprend l'augmentation de la bande passante du filtre à bande passante variable (27) lorsque le VCO est en train de se verrouiller et la diminution de la bande passante du filtre à bande passante variable (27) lorsque le VCO (18) s'est verrouillé sur une amplitude.
